# EUROPEAN PATENT APPLICATION

(11) **EP 4 794 200 A1**
(43) Date of publication of application: **19.08.2026**
(21) Application number: 24939057.6
(22) Date of filing: 20.12.2024
(51) Int. Cl.: H03K 19/017, H03F 3/185, H03F 3/217, H03K 17/16, H03K 19/003

(54) **LOAD DRIVER, AUDIO AMPLIFIER, CHIP AND ELECTRONIC DEVICE**

(71) Applicant: Shenzhen Goodix Technology Co., Ltd., Shenzhen, Guangdong 518045 (CN)
(72) Inventor: MENG, Xin, Shenzhen, Guangdong 518045 (CN); YANG, Yuqing, Shenzhen, Guangdong 518045 (CN); LI, Bohao, Shenzhen, Guangdong 518045 (CN)
(74) Representative: Kraus & Lederer PartGmbB
(86) International application number: PCT/CN2024/141124
(87) International publication number: WO 2026/129320

(57) **Abstract**

Embodiments of the present disclosure provide a load driver, an audio amplifier, a chip, and an electronic device. The load driver comprises an output stage and a control module. The control module is connected to the output stage; and the control module is configured to control the output stage so that an output node of the output stage outputs a load drive signal, a rising edge of the load drive signal has a plurality of segments, and a rising slope of a previous segment among the plurality of segments of the rising edge is larger than a rising slope of a next segment. Based on the above solutions, the load driver provided in the embodiments of the present disclosure has a high switch-on speed, and satisfies EMI requirements.

## Description

### TECHNICAL FIELD

Embodiments of the present disclosure relate to the field of audio amplification, and particularly relate to a load driver, an audio amplifier, a chip, and an electronic device.

### BACKGROUND

A class D audio amplifier is widely used in the audio field because it can provide efficient audio drive. The class D audio amplifier generally comprises an audio modulation circuit and a load driver (e.g., an H-bridge drive circuit) coupled to a modulation circuit. The audio modulation circuit is configured to perform pulse width modulation (PWM) on a received audio signal to obtain an audio modulation signal. The load driver is configured to control switch-on and switch-off of a plurality of power output transistors in its output stage based on the audio modulation signal to apply a load drive signal to a load (e.g., a speaker). With the development of audio modulation technology, the audio modulation circuit can output an audio modulation signal with a small pulse width at a high frequency. This requires that the load driver must have an ability to output a pulse with a small width (e.g., pulse width smaller than 10 ns-20 ns).

In order to enable the load driver to have the ability to output a pulse with a small width, in the related art, a voltage slew rate of a voltage applied to a gate electrode of an output power transistor is increased to reduce delay of an output stage, and increase switch-on speed of the output stage. However, too fast switch-on speed will cause power supply disturbance and electromagnetic interference (EMI) at an output terminal of the load driver.

Therefore, there is an urgent need for a load driver that can have a fast switch-on speed and satisfy EMI requirements.

### SUMMARY

In view of this, embodiments of the present disclosure provide a load driver, an audio amplifier, a chip, and an electronic device, to at least partially solve the above problems.

According to an embodiment in a first aspect of the present disclosure, a load driver is provided, comprising: an output stage and a control module; wherein the control module is connected to the output stage; and the control module is configured to control the output stage so that an output node of the output stage outputs a load drive signal, a rising edge of the load drive signal has a plurality of segments, and a rising slope of a previous segment among the plurality of segments of the rising edge is larger than a rising slope of a next segment.

According to an embodiment in a second aspect of the present disclosure, an audio amplifier is provided, comprising: an audio modulation circuit and the load driver provided according to the first aspect; wherein the audio modulation circuit is configured to generate an audio modulation signal based on an audio signal; and the load driver is configured to generate a load drive signal based on the audio modulation signal.

According to an embodiment in a third aspect of the present disclosure, a chip is provided, comprising the load driver provided according to the first aspect.

According to an embodiment in a fourth aspect of the present disclosure, an electronic device is provided, comprising the chip provided according to the third aspect.

In the load driver provided in the embodiments of the present disclosure, a control module is connected to an output stage; and the control module controls the output stage so that an output node of the output stage outputs a load drive signal, a rising edge of the load drive signal has a plurality of segments, and a rising slope of a previous segment among the plurality of segments of the rising edge is larger than a rising slope of a next segment. The large rising slope of the previous segment among the plurality of segments of the rising edge of the load drive signal indicates that the load drive signal rises fast, which means that the output stage is fast switched on and the output stage has a small delay. Moreover, the small rising slope of the next segment among the plurality of segments of the rising edge of the load drive signal indicates that change of the load drive signal is slowed down, thereby avoiding causing a large peak current on the power supply, which causes power supply disturbance and EMI deterioration. Therefore, the load driver provided in the embodiments of the present disclosure can have a high switch-on speed and satisfy EMI requirements.

### BRIEF DESCRIPTION OF DRAWINGS

To more clearly describe technical solutions of embodiments of the present disclosure or the prior art, drawings to be used in the description of the embodiments or the prior art will be briefly introduced below. Apparently, the drawings in the description below are merely some embodiments disclosed in the embodiments of the present disclosure. For those of ordinary skills in the art, other drawings may also be obtained based on these drawings.
FIG. 1 is a schematic structural diagram of a load driver provided in an embodiment of the present disclosure;
FIG. 2 is a schematic structural diagram of another load driver provided in an embodiment of the present disclosure;
FIG. 3 is a temporal waveform diagram of a related signal provided in an embodiment of the present disclosure;
FIG. 4 is a schematic structural diagram of another load driver provided in an embodiment of the present disclosure;
FIG. 5 is a temporal waveform diagram of a first control signal and a related signal provided in an embodiment of the present disclosure;
FIG. 6 is a schematic structural diagram of a first rate control module in the load driver shown in FIG. 4;
FIG. 7 is a schematic structural diagram of a first rate control module in the load driver shown in FIG. 4;
FIG. 8 is a schematic structural diagram of a first rate control module in the load driver shown in FIG. 4;
FIG. 9 is a schematic structural diagram of another load driver provided in an embodiment of the present disclosure;
FIG. 10 is a schematic structural diagram of another load driver provided in an embodiment of the present disclosure; and
FIG. 11 is a schematic structural diagram of an audio amplifier provided in an embodiment of the present disclosure.

### DETAILED DESCRIPTION

To enable those skilled in the art to better understand technical solutions of embodiments of the present disclosure, the technical solutions of the embodiments of the present disclosure will be clearly and completely described below with reference to the drawings in the embodiments of the present disclosure. Apparently, the described embodiments are merely some, instead of all, of the embodiments of the present disclosure. All other embodiments obtained by those of ordinary skills in the art based on some embodiments among the embodiments of the present disclosure should be encompassed within the scope of protection of the embodiments of the present disclosure.

Specific implementations of the embodiments of the present disclosure will be further described below with reference to the drawings in the embodiments of the present disclosure.

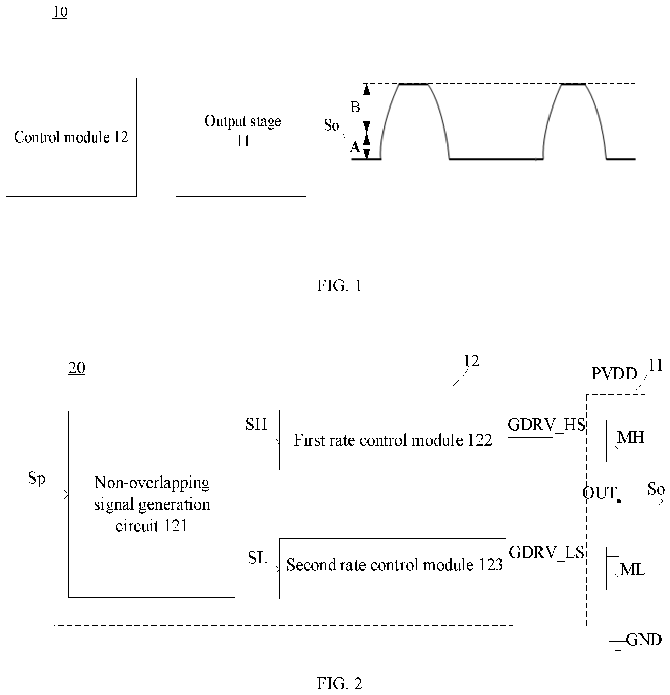

First, referring to FIG. 1, a schematic structural diagram of a load driver provided in an embodiment of the present disclosure is shown. The load driver 10 provided in this embodiment can be applied to an audio power amplifier for providing a load drive signal to a connected load (such as a speaker).

As shown in FIG. 1, the load driver 10 comprises an output stage 11 and a control module 12. The control module 12 is connected to the output stage 11. The control module 12 is configured to control the output stage 11, so that an output node of the output stage 11 outputs a load drive signal So. A rising edge of the load drive signal So has a plurality of segments, and a rising slope of a previous segment among the plurality of segments of the rising edge is larger than a rising slope of a next segment.

For ease of understanding, FIG. 1 shows an example waveform of the load drive signal So. As shown in FIG. 1, the rising edge of the load drive signal So comprises a segment A and a segment B, and a rising slope of the segment A is obviously larger than a rising slope of the segment B. It should be understood that the load drive signal So shown in FIG. 1 is only an example. In a practical application, the load drive signal So may further comprise more than two segments, which is not limited in this embodiment.

In this embodiment, the large rising slope of the previous segment among the plurality of segments of the rising edge of the load drive signal indicates that the load drive signal rises fast, which means that the output stage is fast switched on and the output stage has a small delay. Moreover, the small rising slope of the next segment among the plurality of segments of the rising edge of the load drive signal indicates that change of the load drive signal is slowed down, thereby avoiding causing a large peak current on the power supply, which causes power supply disturbance and EMI deterioration. Therefore, the load driver provided in the embodiment of the present disclosure can have a fast switch-on speed and satisfy EMI requirements.

Based on the load drive signal 10 shown in FIG. 1, FIG. 2 shows a schematic structural diagram of another load drive signal provided in an embodiment of the present disclosure. A load driver 20 shown in FIG. 2 shows internal structures of an output stage 11 and a control module 12 as an example.

As shown in FIG. 2, the output stage 11 comprises a first output power transistor MH coupled between a power supply terminal PVDD and an output node OUT and a second output power transistor ML coupled between the output node OUT and a ground terminal. The output node OUT is used for connection to a load (not shown). The load driver 20 provides a load drive signal So to a load connected to the load driver 20 through the output node OUT.

The control module 12 comprises a non-overlapping signal generation circuit 121, a first rate control module 122, and a second rate control module 123.

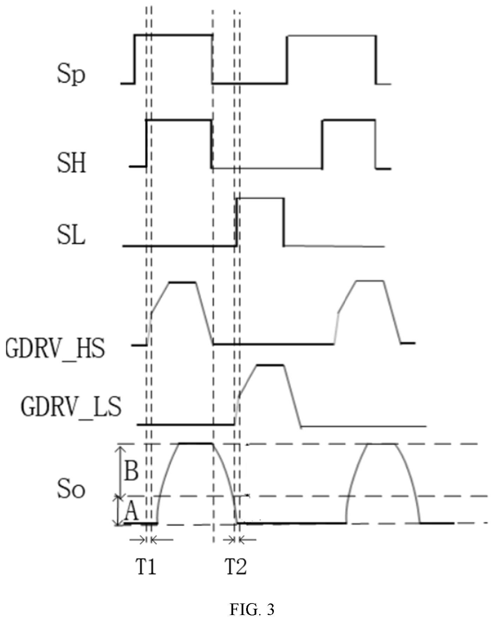

The non-overlapping signal generation circuit 121 is configured to receive an audio modulation signal Sp, and generate a first signal SH and a second signal SL that do not overlap in phase based on the audio modulation signal Sp. The first signal SH and the second signal SL are staggered in phase to ensure that when one of the first signal SH and the second signal SL is in a high phase, the other signal is always in a low phase. For example, the non-overlapping signal generation circuit 121 can ensure a time interval between the first signal SH and the second signal SL using digital logic gates (such as a series of triggers and logic gates), and generate the first signal SH and the second signal SL using a rising edge and a falling edge of the audio modulation signal Sp. The non-overlapping of the first signal SH and the second signal SL in phase can avoid the occurrence of a shoot-through current due to simultaneous switch-on of the first output power transistor MH and the second output power transistor ML. The audio modulation signal Sp is generated by an audio modulation circuit (not shown) for adjusting duty cycles of the first signal SH and the second signal SL. Specifically, the non-overlapping signal generation circuit 121 comprises an input terminal, a first output terminal, and a second output terminal. The input terminal of the non-overlapping signal generation circuit 121 is connected to the audio modulation circuit for receiving the audio modulation signal Sp. A first output terminal of the non-overlapping signal generation circuit 121 is connected to the first rate control module 122 for providing the first signal SH to the first rate control module 122. A second output terminal of the non-overlapping signal generation circuit 121 is connected to the second rate control module 123 for providing the second signal SL to the second rate control module 123. For ease of understanding, FIG. 3 shows example waveforms of the audio modulation signal Sp, the first signal SH, and the second signal SL.

The first rate control module 122 is configured to control switch-on and switch-off of the first output power transistor MH based on the first signal SH. The second rate control module 123 is configured to control switch-on and switch-off of the second output power transistor ML based on the second signal SL.

In this embodiment, in order to enable the load driver 20 to have an ability to output a pulse with a small width while satisfying EMI requirements, the first rate control module 122 is further configured to: control a voltage slew rate of a gate voltage of the first output power transistor MH based on the first signal SH and a delay signal of the first signal SH, so that a rising edge of the load drive signal So outputted from the load driver 20 has a plurality of segments, and a rising slope of a previous segment among the plurality of segments of the rising edge is larger than a rising slope of a next segment. For example, the load drive signal So shown in FIGS. 1 and 3 is outputted.

In this embodiment, a waveform of the rising edge of the load drive signal So is achieved mainly by controlling the switch-on of the first output power transistor MH by the first rate control module 122. As shown in FIG. 3, as the first signal SH is switched from a low level to a high level, that is, in response to a rising edge of the first signal SH, the first output power transistor MH changes from switch-off to switch-on, and the load drive signal So gradually rises from a first voltage level to a second voltage level. During a period when the first signal SH remains at the high level, the first output power transistor MH remains to be switched on, and the load drive signal remains at the second voltage level.

When the load drive signal So gradually rises from the first voltage level to the second voltage level, a rising slope is associated with the voltage slew rate of the gate voltage of the first output power transistor MH. Specifically, the rising slope of the load drive signal So is positively correlated with the voltage slew rate of the gate voltage of the first output power transistor MH. The voltage slew rate of the gate voltage is an amplitude of the gate voltage rising in unit time. The larger the voltage slew rate of the gate voltage is, the larger the amplitude of the gate voltage rises in unit time is; and otherwise, the smaller the amplitude of the gate voltage rises in unit time.

The first output power transistor MH will be switched on only when its gate voltage reaches a threshold voltage Vth. When the gate voltage of the first output power transistor MH does not reach its threshold voltage Vth, the first output power transistor MH is not switched on, which has no effect on the output. Therefore, in a first stage when the first output power transistor MH is switched from switch-off to switch-on, the gate voltage of the first output power transistor MH can be controlled to be boosted quickly to Vth at a large voltage slew rate, thereby increasing the switch-on speed of the first output power transistor MH, and reducing the delay of the output stage. As shown in FIG. 3, within a first duration T1 starting from the rising edge of the first signal SH, an amplitude of a gate voltage GDRV_HS of the first output power transistor MH increases rapidly, that is, the gate voltage GDRV_HS of the first output power transistor MH has a large voltage slew rate. Accordingly, the waveform of the load drive signal So at the output node has a large rising slope.

Then, in a second stage when the first output power transistor MH is switched from switch-off to switch-on, the gate voltage of the first output power transistor MH can be controlled to be boosted at a small voltage slew rate, thereby slowing down the rising speed of the load drive signal at the output node, and avoiding the occurrence of a peak current with a large peak value on the power supply, which causes the power supply disturbance and EMI deterioration. As shown in FIG. 3, after the first duration T1 starting from the rising edge of the first signal, the amplitude of the gate voltage GDRV_HS of the first output power transistor MH increases slowly, that is, the gate voltage GDRV_HS of the first output power transistor MH has a small voltage slew rate. Accordingly, the waveform of the load drive signal So at the output node has a small rising slope.

In an embodiment of the present disclosure, the voltage slew rate of the gate voltage of the first output power transistor is controlled segmentwise based on the first signal and the delay signal of the first signal, so that in the first stage when the first output power transistor MH is switched from switch-off to switch-on, the first output power transistor MH can be switched on quickly, and after the first duration T1 starting from the rising edge of the first signal, the load drive signal at the output node rises slowly, thereby avoiding the occurrence of a peak current with a large peak value on the power supply, which causes the power supply disturbance and EMI deterioration.

In order to further improve the switch-on speed of the load driver and ensure that the load driver satisfies the EMI requirements, in an embodiment of the present disclosure, the second rate control module 123 is configured to control a gate voltage of the second output power transistor ML based on the second signal SL and a delay signal of the second signal SL, so that a rising edge of the gate voltage of the second output power transistor ML comprises a plurality of segments, and a slew rate of a previous segment is larger than a slew rate of a next segment.

Similar to the first output power transistor MH, the second output power transistor ML will be switched on only when its gate voltage reaches its threshold voltage Vth. Before the second output power transistor ML does not reach its threshold voltage Vth, the second output power transistor ML is not switched on, which has no effect on the output. Therefore, as shown in FIG. 3, in a first stage when the second output power transistor ML is switched from switch-off to switch-on (i.e., within a second duration T2 starting from a rising edge of the second signal SL), an amplitude of a gate voltage GDRV_LS of the second output power transistor ML increases rapidly, i.e., the gate voltage GDRV_LS of the second output power transistor ML has a large voltage slew rate, thereby increasing the switch-on speed of the second output power transistor ML, and reducing the delay of the output stage. Then, in a second stage when the second output power transistor ML is switched from switch-off to switch-on (i.e., after the second duration T2 starting from the rising edge of the second signal SL), the amplitude of the gate voltage GDRV_LS of the second output power transistor ML increases slowly, i.e., the gate voltage GDRV_LS of the second output power transistor ML has a relatively small voltage slew rate, thereby avoiding the occurrence of a peak current with a large peak value on the power supply, which causes the power supply disturbance and EMI degradation.

In this embodiment, the power supply terminal PVDD is configured to receive a high voltage, such as a power supply voltage provided by a power supply. The ground terminal GND is configured to receive a low voltage, such as being electrically connected to ground, to receive a ground voltage. Since an NMOS transistor has a larger electron mobility of than a PMOS transistor, at an equal drain-source on-resistance, the NMOS transistor will have a smaller volume. Therefore, in order to save the chip area, as shown in FIG. 2, the first output power transistor MH and the second output power transistor ML may be NMOS transistors. Specifically, a drain electrode of the first output power transistor MH is coupled to the power supply terminal PVDD, and a source electrode of the first output power transistor MH is coupled to the output node. A drain electrode of the second output power transistor ML is coupled to the output node, and a source electrode of the second output power transistor ML is coupled to the ground terminal. A gate electrode of the first output power transistor MH is connected to the first rate control module 122, and a gate electrode of the second output power transistor ML is connected to the second rate control module 123.

For the NMOS transistor, in order to be able to output the first voltage level equal to the power supply voltage at the output node, a boosted voltage higher than the power supply voltage provided by the power supply terminal PVDD can be used to power the first rate control module 122 and a part of a circuit corresponding to the first output power transistor MH. Therefore, a boosted circuit can be additionally provided to boost the power supply voltage provided by the power supply terminal PVDD, and provide the boosted voltage to the first rate control module 122 and the part of the circuit corresponding to the first output power transistor MH for power supply.

However, in order to simplify the circuit structure, in another embodiment of the present disclosure, the first output power transistor MH is a PMOS transistor, and the second output power transistor ML is an NMOS transistor. Specifically, the source electrode of the first output power transistor MH is coupled to the power supply terminal PVDD, and the drain electrode of the first output power transistor MH is coupled to the output node. A drain electrode of the second output power transistor ML is coupled to the output node, and a source electrode of the second output power transistor ML is coupled to the ground terminal. A gate electrode of the first output power transistor MH is connected to the first rate control module 122, and a gate electrode of the second output power transistor ML is connected to the second rate control module 123. In this case, voltages of the first rate control module 122 and a further part corresponding to the first output power transistor MH are directly provided by the power supply voltage provided by the power supply terminal PVDD for power supply without the need to additionally provide the boosted circuit.

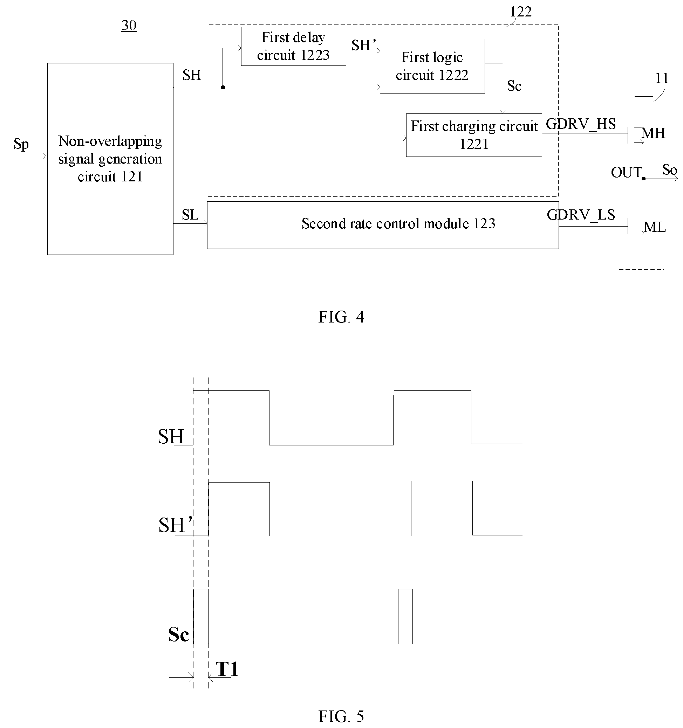

Based on the load drivers shown in FIGS. 1 and 2, FIG. 4 shows a schematic structural diagram of another load driver provided in an embodiment of the present disclosure. An example structure of the first rate control module 122 is shown in the load driver 30 shown in FIG. 4. As shown in FIG. 4, the first rate control module 122 comprises a first charging circuit 1221 and a first logic circuit 1222.

The first charging circuit 1221 is connected to a gate electrode of the first output power transistor MH for providing the gate voltage to the gate electrode of the first output power transistor MH.

The first logic circuit 1222 is configured to generate a first control signal Sc based on the first signal SH and a delay signal SH' of the first signal, and control a charging rate of the first charging circuit 1221 based on the first control signal Sc, to control the voltage slew rate of the gate voltage provided to the first output power transistor MH.

Specifically, the first charging circuit 122 is configured to provide the gate voltage to the gate electrode of the first output power transistor MH. The larger the charging rate of the first charging circuit 1221 is, the larger the voltage slew rate of the gate voltage of the first output power transistor MH is; and otherwise, the smaller the voltage slew rate of the gate voltage of the first output power transistor MH is. That is, the charging rate of the first charging circuit 1221 is positively correlated with the voltage slew rate of the gate voltage of the first output power transistor MH. Therefore, the first logic circuit 1222 generates a first control signal Sc based on the first signal SH and the delay signal SH' of the first signal, and controls the charging rate of the first charging circuit 1221 based on the first control signal Sc, to control the gate voltage of the first output power transistor MH to have different voltage slew rates.

In an implementation of the present disclosure, a rising edge of the first control signal Sc is synchronous with the rising edge of the first signal SH, and a falling edge of the first control signal Sc is synchronous with a rising edge of the delay signal SH' of the first signal. The first logic circuit 1222 is configured to: control the first charging circuit to operate at a first charging rate based on the rising edge of the first control signal Sc; and control the first charging circuit to operate at a second charging rate based on the falling edge of the first control signal Sc, wherein the second charging rate is smaller than the first charging rate.

Since the second charging rate is smaller than the first charging rate, in the first stage when the first output power transistor MH is switched from switch-off to switch-on, the first charging circuit charges the first output power transistor MH at a large charging rate, to boost the gate voltage charged by the first output power transistor MH at a large voltage slew rate, thereby increasing the switch-on speed of the first output power transistor MH, and reducing the delay of the output stage. Then, in the second stage when the first output power transistor MH is switched from switch-off to switch-on, the first charging circuit charges the first output power transistor MH at a small charging rate, to boost the gate voltage of the first output power transistor MH at a small voltage slew rate, and slow down the rising speed of the load drive signal at the output node, thereby avoiding the occurrence of a peak current with a large peak value on the power supply, which causes the power supply disturbance and EMI deterioration.

In this embodiment, as shown in FIG. 4, the delay signal SH' of the first signal can be obtained through processing the first signal SH by a first delay circuit 1223. Therefore, in a possible implementation, the first rate control module 122 may further comprise the first delay circuit 1223. The first delay circuit 1223 is coupled between the first output terminal of the non-overlapping signal generation circuit 121 and an input terminal of the first logic circuit 1222. The first delay circuit 1223 is configured to delay the rising edge of the first signal SH by the first duration T1 to obtain a first delay signal SH' as the delay signal of the first signal; and the first logic circuit 1222 is configured to perform an Exclusive OR (XOR) operation on the first signal SH and the first delay signal SH' to obtain the first control signal Sc.

For example, in this embodiment, the first delay circuit 1223 can be implemented using an asymmetric inverter, so that the first delay circuit 1223 can only delay the rising edge of the first signal, thereby obtaining the delay signal SH' of the first signal as shown in FIG. 5. The rising edge of the first control signal Sc outputted from the first logic circuit 1222 based on the first signal SH and the delay signal SH' of the first signal is synchronous with the rising edge of the first signal SH, and the falling edge of the first control signal Sc outputted from the first logic circuit 1222 is synchronous with the rising edge of the delay signal SH' of the first signal. The first control signal Sc is a pulse signal with a width equal to the first duration T1. In an embodiment of the present disclosure, the first control signal may also be generated using a further logic circuit based on the first delay circuit 1223, which is not limited to in this embodiment.

Based on the load driver shown in FIG. 4, an embodiment of the present disclosure provides another load driver. In this embodiment, the first charging circuit is an RC charging circuit. The first charging circuit comprises a first adjustable resistor module and/or a first adjustable capacitor module. The first logic circuit is configured to control a resistance value of the first adjustable resistor module and/or a capacitance value of the first adjustable capacitor module based on the first control signal, so that the first charging circuit has different charging rates, wherein the resistance value of the first adjustable resistor module and the capacitance value of the first adjustable capacitor module are negatively correlated with the charging rate of the first charging circuit.

Specifically, the charging rate of the RC charging circuit is negatively correlated with a charging time constant of the RC charging circuit. Specifically, the larger the RC charging time constant is, the slower the RC charging rate is; and otherwise, the faster the RC charging rate is. In addition, the charging time constant of the RC charging circuit is positively correlated with a resistance value and a capacitance value of the RC charging circuit. Specifically, the larger the charging time constant of the RC charging circuit and the resistance value and/or capacitance value of the RC charging circuit are, the larger the charging time constant of the RC charging circuit is; and otherwise, the smaller the charging time constant of the RC charging circuit is. On this basis, in an embodiment of the present disclosure, the first charging circuit is set as the RC charging circuit, the first charging circuit comprises the first adjustable resistor module and/or the first adjustable capacitor module, and then the resistance value of the first adjustable resistor module and/or the capacitance value of the first adjustable capacitor module are controlled based on the first control signal, so that the first charging circuit has different charging time constants, and then the first charging circuit can be controlled to have different charging rates.

For example, in an implementation of the present disclosure, the rising edge of the first control signal Sc is synchronous with the rising edge of the first signal SH, and the falling edge of the first control signal Sc is synchronous with the rising edge of the delay signal SH' of the first signal. The first logic circuit 1022 is configured to: control the first adjustable resistor module to have a first resistance value and/or the first adjustable capacitor module to have a first capacitance value based on the rising edge of the first control signal Sc; and control the first adjustable resistor module to have a second resistance value and/or the first adjustable capacitor module to have a second capacitance value based on the falling edge of the first control signal Sc, wherein the first resistance value is smaller than the second resistance value, and the first capacitance value is smaller than the second capacitance value.

Since the first resistance value is smaller than the second resistance value, and the first capacitance value is smaller than the second capacitance value, in response to the rising edge of the first control signal Sc, the first charging circuit has a small charging time constant, so that in the first stage when the first output power transistor MH is switched from switch-off to switch-on, the first charging circuit operates at a large charging rate, to boost the gate voltage of the first output power transistor at a large voltage slew rate, thereby increasing the switch-on speed of the first output power transistor MH, and reducing the delay of the output stage. Then, in the second stage when the first output power transistor MH is switched from switch-off to switch-on, in response to the falling edge of the first control signal Sc, the first charging circuit has a large charging time constant, and the first charging circuit operates at a small charging rate, to boost the gate voltage of the first output power transistor MH at a small voltage slew rate to slow down the rising speed of the load drive signal at the output node, thereby avoiding the occurrence of a peak current with a large peak value on the power supply, which causes the power supply disturbance and EMI deterioration.

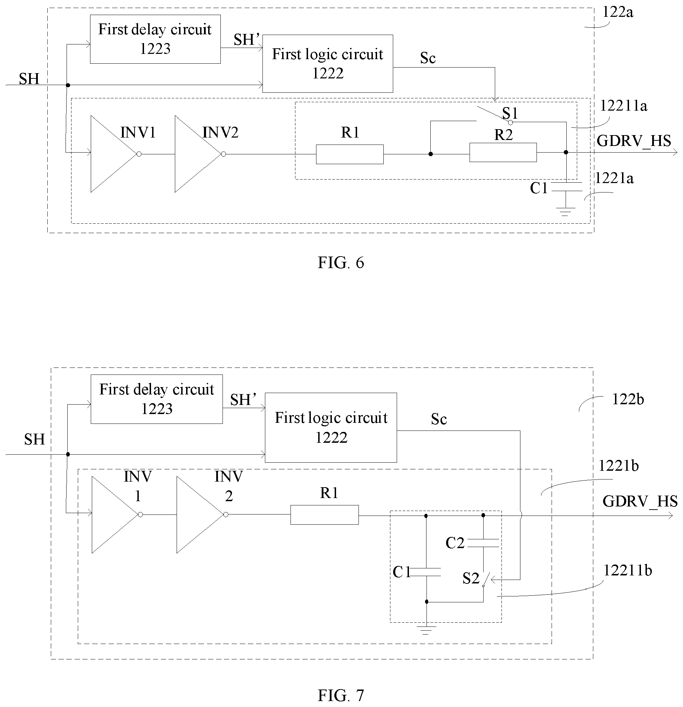

For ease of understanding, two possible implementations of the first charging circuit being an RC charging circuit are given below with reference to FIGS. 6 and 7. As shown in FIGS. 6 and 7, each of first charging circuits 1221a and 1221b is an RC charging circuit. A first input terminal of each of the first charging circuits 1221a and 1221b is connected to the first output terminal of the non-overlapping signal generation circuit 121 for receiving the first signal SH. A second input terminal of each of the first charging circuits 1221a and 1221b is connected to an output terminal of the first logic circuit 1222 for receiving the first control signal Sc. An output terminal of each of the first charging circuits 1221a and 1221 is connected to the gate electrode of the first output power transistor MH for providing the gate voltage to the first output power transistor MH. The difference between the first charging circuits 1221a and 1221b shown in FIGS. 6 and 7 is that the first charging circuit 1221a shown in FIG. 6 comprises a first adjustable resistor module 12211a, and the first charging circuit 1221b shown in FIG. 7 comprises a first adjustable capacitor module 12211b.

Specifically, as shown in FIG. 6, the first charging circuit 1221a comprises a first inverter INV1, a second inverter INV2, a first adjustable resistor module 12211a, a first capacitor C1, and a first switch S1. A first terminal of the first adjustable resistor module 12211a is connected to the first output terminal of the non-overlapping signal generation circuit 121 via the first inverter INV1 and the second inverter INV2 connected in series, for receiving the first signal SH. A second terminal of the first adjustable resistor module 12211a is connected to the gate electrode of the first output power transistor MH, and is connected to a ground terminal GND via the first capacitor C1. The first signal SH charges the first capacitor C1 via the first adjustable resistor module 12211a to provide the gate voltage to the gate electrode of the first output power transistor MH.

In this embodiment, the first adjustable resistor module 12211a comprises a first resistor R1, a second resistor R2, and a first switch S1. The first resistor R1 is connected to the second resistor R2 in series, and the first switch S1 is connected to both terminals of the second resistor R2 in parallel. The first switch S1 is configured to: be switched on in response to the rising edge of the first control signal Sc outputted from the first logic circuit 1222; and be switched off in response to the falling edge of the first control signal Sc outputted from the first logic circuit 1222.

When the load driver is working, the first logic circuit 1222 controls the first switch S1 to be switched on based on the rising edge of the first control signal Sc, so that the resistance value of the first charging circuit 1221a is equal to resistance value of the first resistor R1. In this case, the first charging circuit 1221a has a first charging time constant, and a charging rate corresponding to the first charging time constant is the first charging rate. Then, the first logic circuit 1222 controls the first switch S1 to be switched off based on the falling edge of the first control signal Sc, so that the resistance value of the first charging circuit 1221a is equal to a sum of the resistance value of the first resistor R1 and resistance value of the second resistor R2. In this case, the first charging circuit 1221a has a second charging time constant, and a charging rate corresponding to the second charging time constant is the second charging rate. Since the charging time constant of the RC circuit is proportional to resistance value of the RC circuit, the first charging time constant is smaller than the second charging time constant, and accordingly, the first charging rate is larger than the second charging rate. Therefore, in the first stage when the first output power transistor MH is switched from switch-off to switch-on, the first charging circuit 1221a operates at a large first charging rate, to boost the gate voltage of the first output power transistor MH at a large voltage slew rate, thereby increasing the switch-on speed of the first output power transistor MH, and reducing the delay of the output stage. Then, in the second stage when the first output power transistor MH is switched from switch-off to switch-on, it works at a small charging rate, to boost the gate voltage of the first output power transistor MH at a small voltage slew rate, and slow down the rising speed of the load drive signal at the output node, thereby avoiding the occurrence of a peak current with a large peak value on the power supply, which causes the power supply disturbance and EMI deterioration.

In an implementation shown in FIG. 7, the first charging circuit 1221b comprises a first inverter INV1, a second inverter INV2, a first resistor R1, and a first adjustable capacitor module 12211b. A first terminal of the first resistor R1 is connected to the first output terminal of the non-overlapping signal generation circuit 1032 via the first inverter INV1 and the second inverter INV2, for receiving the first signal SH. A second terminal of the first resistor R1 is connected to the gate electrode of the first output power transistor MH, and is grounded via the first adjustable capacitor module 12211b. The first signal SH charges the first adjustable capacitor module 12211b via the first resistor R1 to provide the gate voltage to the gate electrode of the first output power transistor MH.

In this embodiment, the first adjustable capacitor module 12211b comprises a first capacitor C1, a second capacitor C2, and a second switch S2. A first terminal of the second capacitor C2 is connected to a first terminal of the first capacitor C1, and a second terminal of the second capacitor C2 is connected to a second terminal of the first capacitor C1 via the second switch S2. The second switch S2 is configured to: be switched off in response to the rising edge of the first control signal Sc outputted from the first logic circuit 1222; and be switched on in response to the falling edge of the first control signal Sc outputted from the first logic circuit 1222.

When the load driver is working, the first logic circuit 1222 controls the second switch S2 to be switched off based on the rising edge of the first control signal Sc, so that capacitance value of the first charging circuit 1221b is equal to capacitance value of the first capacitor C1. In this case, the first charging circuit 1221b has a first charging time constant, and a charging rate corresponding to the first charging time constant is the first charging rate. Then, the first logic circuit 1222 controls the second switch S2 to be switched on based on the falling edge of the first control signal Sc, so that the capacitance value of the first charging circuit 1221b is equal to parallel capacitance value of the first capacitor C1 and the second capacitor C2. In this case, the first charging circuit 1221b has a second charging time constant, and a charging rate corresponding to the second charging time constant is the second charging rate. Since the charging time constant of the RC circuit is proportional to the capacitance value of the RC circuit, the first charging time constant is smaller than the second charging time constant, and accordingly, the first charging rate is larger than the second charging rate, thereby boosting the gate voltage of the first output power transistor MH at a large voltage slew rate in the first stage when the first output power transistor MH is switched from switch-off to switch-on, and then boosting the gate voltage of the first output power transistor MH at a relatively small voltage slew rate in the second stage when the first output power transistor MH is switched from switch-off to switch-on.

It should be understood that FIGS. 6 and 7 are only an example. In other implementations, the first charging circuit may comprise both a first adjustable resistor module and a first adjustable capacitor module. In addition, circuit structures of the first adjustable circuit module and the first adjustable capacitor module can be set based on actual requirements, as long as the resistance value and/or the capacitance value of the first charging circuit are variable, which is not limited in this embodiment.

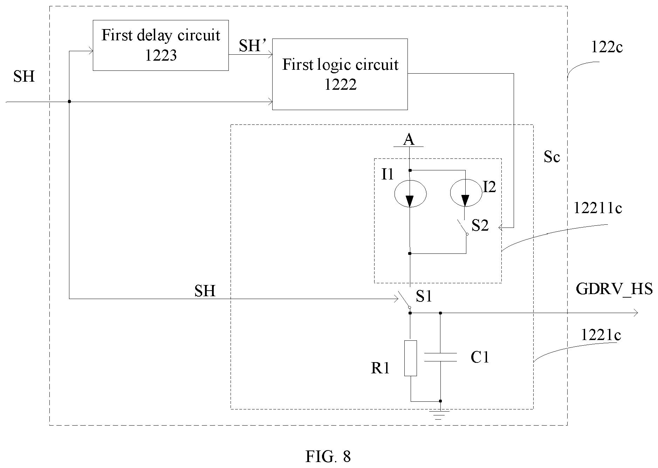

In order to accurately control the current flowing into the gate electrode of the first output power transistor, FIG. 8 shows a schematic structural diagram of another first rate control module provided in an embodiment of the present disclosure. In the first rate control module 122c shown in FIG. 8, a first charging circuit 1221c is a constant current charging circuit, and the first charging circuit 1221c comprises a first adjustable current source module 12211c. The first logic circuit 1222 is configured to control a current provided by the first adjustable current source module 12211c based on the first control signal Sc, so that the first charging circuit 1221c has different charging rates.

As shown in FIG. 8, a first input terminal of the first charging circuit 1221c is connected to the first output terminal of the non-overlapping signal generation circuit 121, a second input terminal of the first charging circuit 1221c is connected to the output terminal of the first logic circuit 1222, and an output terminal of the first charging circuit 1221c is connected to the gate electrode of the first output power transistor MH.

Specifically, as shown in FIG. 8, besides the first adjustable current source module 12211c, the first charging circuit 1221c further comprises a resistor R1, a capacitor C1, and a first switch S1. A first terminal of the first adjustable current source module 12211c is connected to a voltage input terminal A, a second terminal of the first adjustable current source module 12211c is connected to the gate electrode of the first output power transistor MH via the first switch S1, and the resistor R1 and the capacitor C1 are connected in parallel between the gate electrode of the first output power transistor MH and the ground. The first switch S1 is configured to: be switched on in response to the rising edge of the first signal SH outputted from the first output terminal of the non-overlapping signal generation circuit 121; and be switched off in response to the falling edge of the first signal SH outputted from the first output terminal of the non-overlapping signal generation circuit 121.

In this embodiment, when the first output power transistor MH adopts a PMOS transistor, the voltage input terminal A is the power supply terminal PVCC. When the first output power transistor MH adopts an NMOS transistor, the voltage input terminal A is an output terminal of the boosted circuit configured to boost the power supply voltage provided by the power supply terminal PVCC.

In this embodiment, the first adjustable current source module 12211c can provide different currents. As shown in FIG. 8, the first adjustable current source module 12211c comprises a first current source I1, a second current source I2, and a second switch S2. A first terminal of the second current source I2 is connected to a first terminal of the first current source I1, and a second terminal of the second current source I2 is connected to a second terminal of the first current source I1 via the second switch S2. The second switch S2 is configured to: be switched on in response to the rising edge of the first control signal Sc provided by the first logic circuit 1222; and be switched off in response to the falling edge of the first control signal Sc provided by the first logic circuit 1222.

When the load driver is working, the first switch S1 is switched on in response to the rising edge of the first signal SH. The first adjustable current source module 12211 c is connected to the gate electrode of the first output power transistor MH for providing the gate voltage to the first output power transistor MH by charging the capacitor C1. Since the rising edges of the first control signal Sc and the first signal SH are synchronous, when the first switch S1 is switched on in response to the rising edge of the first signal SH, the second switch S2 is switched on in response to the rising edge of the first control signal Sc, so that the first adjustable current source module 12211c outputs a first current. The first current is equal to a sum of a current provided by the first current source I1 and a current provided by the second current source I2. In this case, the first charging circuit 1221c charges the capacitor C1 at the first current, and accordingly, the first charging circuit 1221c operates at the first charging rate. Then, the second switch S2 is switched off in response to the falling edge of the first control signal Sc, so that the first adjustable current source module 12211c outputs a second current. The second current is equal to the current provided by the first current source I1. In this case, the first charging circuit 1221 charges the capacitor C1 at the second current, and accordingly, the first charging circuit operates at the second charging rate. When the falling edge of the first signal SH arrives, in response to the falling edge of the first signal SH, the first switch S1 is switched off, and the gate electrode of the first output power transistor MH is discharged through the resistor R1 and the capacitor C1, so that the first output power transistor MH is switched off.

Since the first current is equal to the sum of the current provided by the first current source I1 and the current provided by the second current source I2, and the second current is equal to the current provided by the first current source I1, the first current is larger than the second current, and accordingly, the first charging rate is larger than the second charging rate. Therefore, in the first stage when the first output power transistor MH is switched from switch-off to switch-on, the first charging circuit 12211c operates at a large first charging rate, to boost the gate voltage of the first output power transistor MH at a large voltage slew rate, thereby increasing the switch-on speed of the first output power transistor MH, and reducing the delay of the output stage. Then, in the second stage when the first output power transistor MH is switched from cut-off to switch-on, the first charging circuit 12211c operates at a small charging rate, to boost the gate voltage of the first output power transistor MH at a small voltage slew rate, and slow down the rising speed of the load drive signal at the output node, thereby avoiding the occurrence of a peak current with a large peak value on the power supply, which causes the power supply disturbance and EMI deterioration.

It should be understood that FIG. 8 only shows an implementation of controlling the slew rate of the gate voltage of the first output power transistor MH by controlling a charging current of a constant current source charging circuit. In other embodiments, for the constant current source charging circuit, the slew rate of the gate voltage of the first output power transistor MH may be further controlled by adjusting the size of the capacitor in the constant current charging circuit, or by adjusting the charging current of the constant current source charging circuit and the size of the capacitor, which is not limited in this embodiment.

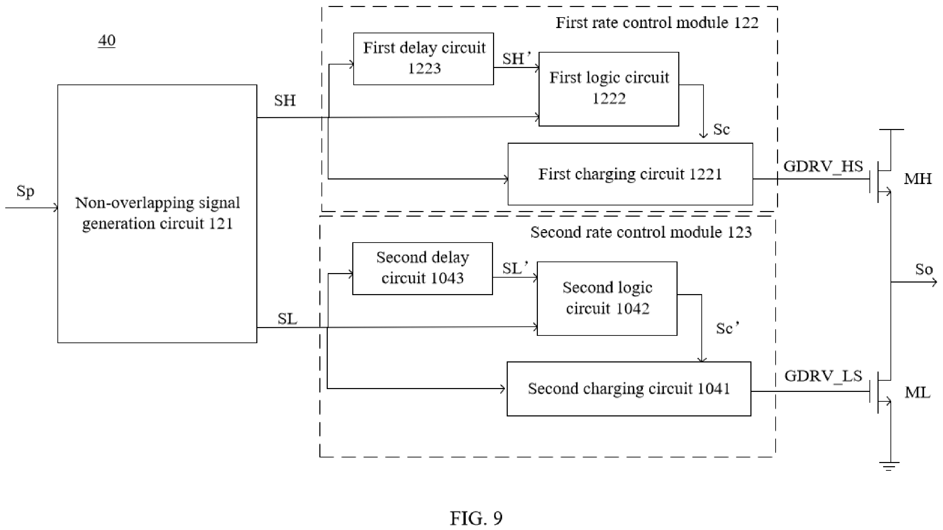

Based on the embodiment shown in FIG. 4, FIG. 9 shows a schematic structural diagram of a load driver provided in an embodiment of the present disclosure. The difference between the load driver provided in the embodiment of the present disclosure and the load driver shown in FIG. 4 is that the load driver shown in FIG. 9 shows a specific structure of the second rate control module 123.

As shown in FIG. 9, the second rate control module 123 comprises a second charging circuit 1041 and a second logic circuit 1042. The second charging circuit 1041 is connected to a gate electrode of the second output power transistor ML for providing the gate voltage to the gate electrode of the second output power transistor ML. The second logic circuit 1042 is configured to generate a second control signal Sc' based on the second signal SL and a delay signal SL' of the second signal, and control a charging rate of the second charging circuit 1041 based on the second control signal Sc' to control a voltage slew rate of the gate voltage of the second output power transistor ML, wherein the charging rate of the second charging circuit 1041 is positively correlated with the voltage slew rate of the gate voltage of the second output power transistor ML.

In an implementation of the present disclosure, a rising edge of the second control signal Sc' is synchronous with a rising edge of the second signal SL, and a falling edge of the second control signal Sc' is synchronous with a rising edge of the delay signal SL' of the second signal. The second logic circuit is configured to: control the second charging circuit 1041 to operate at a third charging rate based on the rising edge of the second control signal Sc'; and control the second charging circuit 1041 to operate at a fourth charging rate based on the falling edge of the second control signal Sc', the fourth charging rate being smaller than the third charging rate.

In an implementation of the present disclosure, the second charging circuit 1041 is an RC charging circuit, the second charging circuit 1041 comprises: a second adjustable resistor module and/or a second adjustable capacitor module; and the second logic circuit 1042 is configured to control a resistance value of the second adjustable resistor module and/or a capacitance value of the second adjustable capacitor module based on the second control signal, so that the second charging circuit has different charging rates, wherein the resistance value of the second adjustable resistor module and the capacitance value of the second adjustable capacitor module are negatively correlated with the charging rate of the second charging circuit.

In an implementation of the present disclosure, a rising edge of the second control signal Sc' is synchronous with a rising edge of the second signal SL, and a falling edge of the second control signal Sc' is synchronous with a rising edge of the delay signal SL' of the second signal. The second logic circuit 1042 is configured to: control the second adjustable resistor module to have a third resistance value and/or the second adjustable capacitor module to have a third capacitance value based on the rising edge of the second control signal Sc'; and control the second adjustable resistor module to have a fourth resistance value and/or the second adjustable capacitor module to have a fourth capacitance value based on the falling edge of the second control signal Sc', wherein the third resistance value is smaller than the fourth resistance value, and the third capacitance value is smaller than the fourth capacitance value.

The third resistance value, the third capacitance value, the fourth resistance value, and the fourth capacitance value in the embodiment of the present disclosure may be equal to or different from the first resistance value, the first capacitance value, the second resistance value, and the second capacitance value in the above embodiments respectively, which is not limited in this embodiment.

In an implementation of the present disclosure, the second charging circuit 1041 is a constant current charging circuit, and the second charging circuit 1041 comprises a second adjustable current module. The second logic circuit 1042 is configured to control a current outputted from the second adjustable current source module based on the second control signal Sc', so that the second charging circuit 1041 has different charging rates, wherein the current outputted from the second adjustable current source module is positively correlated with the charging rate of the second charging circuit 1041.

In an implementation of the present disclosure, a rising edge of the second control signal Sc' is synchronous with a rising edge of the second signal SL, and a falling edge of the second control signal Sc' is synchronous with a rising edge of the delay signal SL' of the second signal. The second logic circuit 1042 is configured to: control the second adjustable current source module to output a third current based on the rising edge of the second control signal Sc'; and control the second adjustable current source module to output a fourth current in response to the falling edge of the second control signal Sc', wherein the third current is larger than the fourth current.

The third current and the fourth current in the embodiment of the present disclosure may be equal to or different from the first current and the second current in the above embodiments respectively, which is not limited in this embodiment.

In an implementation of the present disclosure, the second rate control module 123 further comprises a second delay circuit 1043 coupled to a second output terminal of the non-overlapping signal generation circuit 121 and an input terminal of the second logic circuit 1042. The second delay circuit 1043 is configured to delay the rising edge of the second signal SL by a second duration to obtain a second delay signal SL' as the delay signal of the second signal; and the second logic circuit 1042 is configured to perform an Exclusive OR (XOR) operation on the second signal SL and the second delay signal SL' to obtain the second control signal Sc'.

In this embodiment, the second control signal Sc' is a pulse signal with a width equal to the second duration. The second duration may be equal to or different from the first duration in the above embodiments, which is not limited in the present disclosure.

In this embodiment, the second charging circuit 1041, the second logic circuit 1042, and the second delay circuit 1043 in the second rate control module 123 have similar circuit implementations, working principles, and effects to the first charging circuit 1221, the first logic circuit 1222, and the first delay circuit 1223 in the first rate control module 122 in the above embodiments, which will not be repeated here to avoid redundancy.

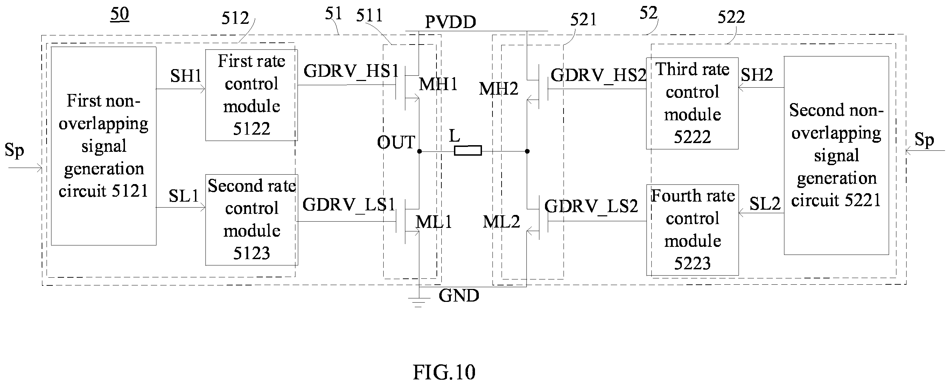

Based on the load driver provided in the above embodiments, FIG. 10 shows another load driver provided according to an embodiment of the present disclosure. The load driver 50 shown in FIG. 10 comprises a first load driver branch circuit 51 and a second load driver branch circuit 52. The first load driver branch circuit 52 and the second load driver branch circuit 52 have similar circuit structures and working principles to the load driver provided in the above embodiments.

For example, an output stage 511 of the first load driver branch circuit 51 comprises a first output power transistor MH1 and a second output power transistor ML1. A control module 512 of the first load driver branch circuit 51 comprises a first non-overlapping signal generation circuit 5121, a first rate control module 5122, and a second rate control module 5123. An output stage 521 of the second load driver branch circuit 52 comprises a third output power transistor MH2 and a fourth output power transistor ML2. A control module 522 of the second load driver branch circuit 52 comprises a second non-overlapping signal generation circuit 5221, a third rate control module 5222, and a fourth rate control module 5223. The circuit structures, control modes, and effects of the corresponding modules in the above load driver can be referred to for circuit structures, control modes, and effects of the modules in the first load driver branch circuit 51 and the second load driver branch circuit 52, which will not be repeated here.

In an embodiment of the present disclosure, a load L is connected between an output node of the output stage 511 of the first load driver branch circuit 51 (i.e., a connection node between a first output power transistor MH1 and a second output power transistor ML1) and an output node of the output stage 521 of the second load driver branch circuit 52 (i.e., a connection node between a third output power transistor MH2 and a fourth output power transistor ML2), so that the output stage 511 of the first load driver branch circuit 51 and the output stage of the second load driver branch circuit 52 are connected through the load L to form an H-bridge circuit. When the load driver 50 is working, one of the first output power transistor MH1 and the second output power transistor ML1 in the first load driver branch circuit 51 is switched on, and one of the third output power transistor MH2 and the fourth output power transistor ML2 in the second load driver branch circuit 52 is switched on, to form a current path to provide a load drive signal to the load.

In an embodiment of the present disclosure, the first output power transistor MH1 and the second output power transistor ML1 in the first load driver branch circuit 51, as well as the third output power transistor MH2 and the fourth output power transistor ML2 in the second load driver branch circuit 52, have same control mode and same effects as the first output power transistor and the second output power transistor in the load driver provided in the above embodiments, and will not be repeated here.

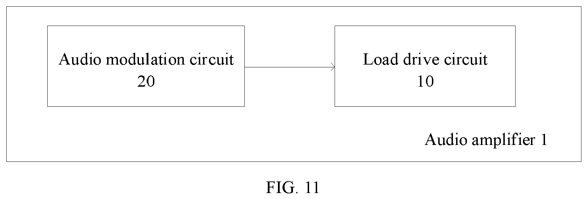

As shown in FIG. 11, an embodiment of the present disclosure further provides an audio amplifier 1, comprising: an audio modulation circuit 20 and a load driver 11. The audio modulation circuit 20 is configured to generate an audio modulation signal from an audio signal. The load driver 11 is configured to generate a load drive signal based on the audio modulation signal.

In an embodiment of the present disclosure, the load driver 10 may be the load driver provided in any one of the above embodiments. The audio amplifier 1 may be a class D audio amplifier. The audio modulation circuit 20 may be any suitable audio modulation circuit, which is not limited in this embodiment.

An embodiment of the present disclosure further provides a chip, comprising the load driver provided according to the above embodiments.

An embodiment of the present disclosure further provides an electronic device, comprising the chip provided according to the above embodiments. The electronic device may be, for example, a portable electronic device such as a mobile phone or a tablet, or may be a vehicle device, etc., which is not limited in this embodiment.

As will be appreciated by those of ordinary skills in the art, the various example units and method steps described in combination with the embodiments disclosed herein can be implemented by electronic hardware, or a combination of computer software and electronic hardware. Whether these functions are executed by hardware or software depends on particular applications and design constraints of the technical solutions. Those skilled in the art may implement the described functions for each particular application using different methods, but such implementation should not be considered as falling beyond the scope of the embodiments of the present disclosure.

The above embodiments are only used to illustrate the embodiments of the present disclosure, and are not intended to limit the embodiments of the present disclosure. Those of ordinary skills in the relevant technical field may further make various alterations and modifications without departing from the spirit and scope of the embodiments of the present disclosure. Therefore, all equivalent technical solutions are also encompassed within the scope of the embodiments of the present disclosure, and the scope of patent protection of the embodiments of the present disclosure should be defined by the claims.

## Claims

1. A load driver, comprising: an output stage and a control module; wherein
the control module is connected to the output stage; and
the control module is configured to control the output stage, so that an output node of the output stage outputs a load drive signal, a rising edge of the load drive signal has a plurality of segments, and a rising slope of a previous segment among the plurality of segments of the rising edge is larger than a rising slope of a next segment.

2. The load driver according to claim 1, wherein
the output stage comprises a first output power transistor coupled between a power supply terminal and the output node; and
the control module is configured to control a voltage slew rate of a gate voltage of the first output power transistor, so that the load drive signal has the plurality of segments, wherein the voltage slew rate of the gate voltage of the first output power transistor is positively correlated with a rising slope of the rising edge of the load drive signal.

3. The load driver according to claim 1, wherein the control module comprises a non-overlapping signal generation circuit and a first rate control module, wherein
the non-overlapping signal generation circuit is configured to generate a first signal based on an audio modulation signal, the first signal being used to control switch-on and switch-off of a first output power transistor; and
the first rate control module is configured to control a voltage slew rate of a gate voltage of the first output power transistor based on the first signal and a delay signal of the first signal, so that the load drive signal has the plurality of segments.

4. The load driver according to claim 3, wherein the first rate control module comprises a first charging circuit and a first logic circuit; wherein
the first charging circuit is connected to a gate electrode of the first output power transistor for providing the gate voltage to the gate electrode of the first output power transistor; and
the first logic circuit is configured to generate a first control signal based on the first signal and the delay signal of the first signal, and control a charging rate of the first charging circuit based on the first control signal to control the voltage slew rate of the gate voltage provided to the first output power transistor, wherein the charging rate of the first charging circuit is positively correlated with the voltage slew rate of the gate voltage of the first output power transistor.

5. The load driver according to claim 4, wherein a rising edge of the first control signal is synchronous with a rising edge of the first signal, a falling edge of the first control signal is synchronous with a rising edge of the delay signal of the first signal; and
the first logic circuit is configured to:
control the first charging circuit to operate at a first charging rate based on the rising edge of the first control signal; and
control the first charging circuit to operate at a second charging rate based on the falling edge of the first control signal, the second charging rate being smaller than the first charging rate.

6. The load driver according to claim 4, wherein the first charging circuit is an RC charging circuit, the first charging circuit comprises a first adjustable resistor module and/or a first adjustable capacitor module; and the first logic circuit is configured to control a resistance value of the first adjustable resistor module and/or a capacitance value of the first adjustable capacitor module based on the first control signal, so that the first charging circuit has different charging rates, wherein the resistance value of the first adjustable resistor module and the capacitance value of the first adjustable capacitor module are negatively correlated with the charging rate of the first charging circuit.

7. The load driver according to claim 6, wherein a rising edge of the first control signal is synchronous with a rising edge of the first signal, a falling edge of the first control signal is synchronous with a rising edge of the delay signal of the first signal; and the first logic circuit is configured to:
control the first adjustable resistor module to have a first resistance value and/or the first adjustable capacitor module to have a first capacitance value based on the rising edge of the first control signal; and
control the first adjustable resistor module to have a second resistance value and/or the first adjustable capacitor module to have a second capacitance value based on the falling edge of the first control signal, wherein the first resistance value is smaller than the second resistance value, and the first capacitance value is smaller than the second capacitance value.

8. The load driver according to claim 4, wherein the first charging circuit is a constant current charging circuit, the first charging circuit comprises a first adjustable current source module; and
the first logic circuit is configured to control a current outputted from the first adjustable current source module based on the first control signal, so that the first charging circuit has different charging rates, wherein the current outputted from the first adjustable current source module is positively correlated with the charging rate of the first charging circuit.

9. The load driver according to claim 8, wherein a rising edge of the first control signal is synchronous with a rising edge of the first signal, a falling edge of the first control signal is synchronous with a rising edge of the delay signal of the first signal; and
the first logic circuit is configured to:
control the first adjustable current source module to output a first current based on the rising edge of the first control signal; and
control the first adjustable current source module to output a second current based on the falling edge of the first control signal, wherein the first current is larger than the second current.

10. The load driver according to any one of claims 3-9, wherein the first rate control module further comprises a first delay circuit coupled between a first output terminal of the non-overlapping signal generation circuit and an input terminal of the first logic circuit; the first delay circuit is configured to delay the rising edge of the first signal by a first duration to obtain a first delay signal as the delay signal of the first signal; and the first logic circuit is configured to perform an Exclusive OR (XOR) operation on the first signal and the first delay signal to obtain the first control signal, wherein the first control signal is a pulse signal with a width equal to the first duration.

11. The load driver according to claim 3, wherein the output stage further comprises a second output power transistor coupled between the output node and a ground terminal;
the non-overlapping signal generation circuit is further configured to generate a second signal that does not overlap with the first signal based on the audio modulation signal, the second signal being used to control switch-on and switch-off of the second output power transistor; and
the control module further comprises a second rate control module configured to control a gate voltage of the second output power transistor based on the second signal and a delay signal of the second signal, so that a rising edge of the gate voltage of the second output power transistor has a plurality of segments, and a voltage slew rate of a previous segment among the plurality of segments of the rising edge is larger than a voltage slew rate of a next segment.

12. The load driver according to claim 11, wherein the second rate control module comprises a second charging circuit and a second logic circuit; wherein
the second charging circuit is connected to a gate electrode of the second output power transistor for providing the gate voltage to the gate electrode of the second output power transistor; and
the second logic circuit is configured to generate a second control signal based on the second signal and the delay signal of the second signal, and control a charging rate of the second charging circuit based on the second control signal to control a voltage slew rate of the gate voltage of the second output power transistor, wherein the charging rate of the second charging circuit is positively correlated with the voltage slew rate of the gate voltage of the second output power transistor.

13. The load driver according to claim 12, wherein a rising edge of the second control signal is synchronous with a rising edge of the second signal, a falling edge of the second control signal is synchronous with a rising edge of the delay signal of the second signal; and the second logic circuit is configured to: control the second charging circuit to operate at a third charging rate based on the rising edge of the second control signal; and control the second charging circuit to operate at a fourth charging rate based on the falling edge of the second control signal, the fourth charging rate being smaller than the third charging rate.

14. The load driver according to claim 13, wherein the second charging circuit is an RC charging circuit, the second charging circuit comprises a second adjustable resistor module and/or a second adjustable capacitor module; and
the second logic circuit is configured to control a resistance value of the second adjustable resistor module and/or a capacitance value of the second adjustable capacitor module based on the second control signal, so that the second charging circuit has different charging rates, wherein the resistance value of the second adjustable resistor module and the capacitance value of the second adjustable capacitor module are negatively correlated with the charging rate of the second charging circuit.

15. The load driver according to claim 14, wherein the rising edge of the second control signal is synchronous with the rising edge of the second signal, the falling edge of the second control signal is synchronous with the rising edge of the delay signal of the second signal; and
the second logic circuit is configured to:
control the second adjustable resistor module to have a third resistance value and/or the second adjustable capacitor module to have a third capacitance value based on the rising edge of the second control signal; and
control the second adjustable resistor module to have a fourth resistance value and/or the second adjustable capacitor module to have a fourth capacitance value based on the falling edge of the second control signal, wherein the third resistance value is smaller than the fourth resistance value, and the third capacitance value is smaller than the fourth capacitance value.

16. The load driver according to claim 13, wherein the second charging circuit is a constant current charging circuit, the second charging circuit comprises a second adjustable current source module; and
the second logic circuit is configured to control a current outputted from the second adjustable current source module based on the second control signal, so that the second charging circuit has different charging rates, wherein the current outputted from the second adjustable current source module is positively correlated with the charging rate of the second charging circuit.

17. The load driver according to claim 16, wherein the rising edge of the second control signal is synchronous with the rising edge of the second signal, the falling edge of the second control signal is synchronous with the rising edge of the delay signal of the second signal; and
the second logic circuit is configured to:
control the second adjustable current source module to output a third current based on the rising edge of the second control signal; and
control the second adjustable current source module to output a fourth current based on the falling edge of the second control signal, wherein the third current is larger than the fourth current.

18. The load driver according to any one of claims 12-17, wherein the second rate control module further comprises a second delay circuit coupled between a second output terminal of the non-overlapping signal generation circuit and an input terminal of the second logic circuit;
the second delay circuit is configured to delay the rising edge of the second signal by a second duration to obtain a second delay signal as the delay signal of the second signal; and
the second logic circuit is configured to perform an Exclusive OR (XOR) operation on the second signal and the second delay signal to obtain the second control signal,
wherein the second control signal is a pulse signal with a width equal to the second duration.

19. An audio amplifier, comprising: an audio modulation circuit and the load driver according to any one of claims 1-18; wherein
the audio modulation circuit is configured to generate an audio modulation signal from an audio signal; and
the load driver is configured to generate a load drive signal based on the audio modulation signal.
